(19) Europäisches Patentamt
European Patent Office
Office européen des brevets

(11) Publication number: **0 434 098 A2**

# (12) EUROPEAN PATENT APPLICATION

(21) Application number: **90125302.1**

(51) Int. Cl.[5]: **G03F 7/031**

(22) Date of filing: **21.12.90**

(30) Priority: **22.12.89 US 455098**

(43) Date of publication of application: **26.06.91 Bulletin 91/26**

(84) Designated Contracting States: **AT BE CH DE DK ES FR GB GR IT LI LU NL SE**

(71) Applicant: **UNION CARBIDE CHEMICALS AND PLASTICS COMPANY, INC.**
**39 Old Ridgebury Road**
**Danbury Connecticut 06817-0001(US)**

(72) Inventor: **Gerkin, Richard Michael**
**5300 Kensington Drive**
**Cross Lanes, West Virginia 25313(US)**
Inventor: **Beckett, Alison Darnell**
**510 Washington Avenue**
**Nitro, West Virginia 25143(US)**
Inventor: **Koleske, Joseph Victor**
**1513 Brentwood Road**
**Charleston, West Virginia 25314(US)**

(74) Representative: **Wuesthoff, Franz, Dr.-Ing. et al**
**Wuesthoff & Wuesthoff Patent- und Rechtsanwälte Schweigerstrasse 2**
**W-8000 München 90(DE)**

## (54) Photo-curable amine-containing compositions.

(57) A photocurable composition comprising a multifunctional amine compound, an ethylenically unsaturated compound, and an aromatic ketone photosensitizer that functions through a hydrogen abstraction mechanism and its use in making cured products.

EP 0 434 098 A2

# PHOTO-CURABLE AMINE-CONTAINING COMPOSITIONS

## BACKGROUND TO THE INVENTION

### Field of the Invention

This invention generally relates to radiation curable amine-containing compositions and photoinitiators useful therein. More particularly, the invention relates to photopolymerizations of ethylenically unsaturated compounds using a combination of a photosensitizer and a multifunctional amine compound.

### Description of the Prior Art

It is known that photopolymerization processes have achieved considerable industrial importance particularly in situations where thin films or layers need to be cured in short times. Typical of such situations are the curing of clear coatings or overprint varnishes, colored coatings, inks, adhesives, printing plates, and the like. Such products are used in a variety of commercial end uses. Although the prime interest is for such thin-film technology, the importance of thick-film or thick-section, radiation-cured technology is growing and increasing in importance. Thick-section technology is important in the area of sealants, adhesives, shaped parts, printing plates, fiber glass- or carbon/graphite fiber-reinforced products, and the like.

The use of aromatic ketones such as benzophenone, benzophenone derivatives, and the like as photosensitizers in the photopolymerization of ethylenically unsaturated compounds is also known in the art. However, some photosensitizers, such as benzophenone, will not function when used alone and require the presence of a second compound, a synergist. In addition, markedly faster polymerization rates can be obtained by the use of combinations of certain aromatic ketones with synergists than is the case when such photosensitizers are used alone. The synergists usually are low molecular weight tertiary amines, ureas, or amides.

Combinations of photosensitizers and synergists that are commonly used include mixtures of one or more aromatic ketones, one of which is benzophenone, isopropylthioxanthone, or the like and a low molecular weight tertiary amine such as dimethylethanol amine, triethylamine, bis-(4,4'-dimethyl-amino)-benzophenone (Michler's ketone), or the like. The combination of photosensitizer and a synergist is termed a photoinitiator system or a photoinitiator combination. Such combinations are said to function through an intermolecular hydrogen abstraction mechanism in which ultraviolet light is absorbed by the aromatic ketone which interacts with an amine or other suitable low molecular weight nitrogen-containing compound that has an alpha-hydrogen and rapidly forms an excited complex. This complex, or "exiplex" as it is often termed, undergoes rearrangement with the transfer of a hydrogen atom from the amine causing the amine to become the free radical initiator molecule that causes rapid polymerization of acrylates and other appropriate ethylenically unsaturated compounds. If used alone, the amine or other nitrogen-containing compound will not effect the polymerization. Although this mechanism is felt to be true, this invention is not limited by it or any other described mechanism.

Use of low molecular weight amines in combination with aromatic or diaryl ketones to form photoinitiator systems is documented in the literature. For example, G. F. Vesley, J. Radiation Curing, 13 (1), 4 (1986) discusses combination diaryl ketone/amine hydrogen-abstracting initiators for the radiation polymerization of acrylates. P. N. Green, Polymers Paint Colour J., 175 (4141), 246 (April 17, 1985) also discusses such compounds and points out that compounds such as benzophenone are usually used in combination with tertiary amines for the ultraviolet light curing of acrylates. Table 9 of this article lists N-methyldiethanolamine, triethanolamine, 2-(dimethylamino)ethylbenzoate, ethyl-4-dimethylaminobenzoate, and n-butoxyethyl-4-dimethylaminobenzoate as examples of coinitiator, tertiary amines that are used in the art.

The use of low molecular weight ureas in polymerization reactions activated by radiation has been described in the art. U. S. Patent No. 3,993,549 describes the addition of powdered urea to liquid polyene-polythiol systems that are to be cured with actinic radiation such as ultraviolet light or ionizing radiation in the presence of photosensitizers such as aromatic ketones.

U. S. Patent Nos. 4,425,208 and 4,518,473 describe methods for the photopolymerization of ethylenically unsaturated compounds wherein combinations of an aromatic ketone photosensitizer and low molecular weight tetrasubstituted ureas and disubstituted amides are employed as the photoinitiators.

U. S. Patent No. 4,446,247 describes liquid photoinitiator compositions that contain an aromatic ketone photosensitizer and a low molecular weight tetrasubstituted urea or disubstituted amide and that are useful

for the radiation activated polymerization of ethylenically unsaturated compounds.

U. S. Patent No. 4,761,435 describes the use of polyamine resins which preferentially are polytertiary amine resins in combination with aryl ketone photosensitizers such as benzophenone. It is preferred that acrylic copolymers containing copolymerized tertiary amine-functional monomers such as dimethylaminoethylacrylate, acrylamide, or methacrylamide be used. It is mentioned that primary amine derivatives of polyoxypropylene compounds can be used and one that is trifunctional in nature with an equivalent weight of 139 (Jeffamine T-403) is listed in a table but is not used in the ensuing examples.

Belgium Patent No. 884,395 deals with the radiation curing of acrylates in combination with low molecular weight compounds of the N-vinyl amide type. The list of suitable compounds in this reference mentions and the patent claims, but does not exemplify, the use of low molecular weight compounds such as N-vinylmethyl-N'-dimethyl urea and other tetrasubstituted, vinyl-containing ureas in combination with acrylates.

Although such known combinations can give very good results in terms of rate of cure, they have a number of disadvantages. The disadvantages include yellowing or other discoloration of the finished polymeric film, unpleasant odors in the liquid formulation and the cured film, health hazards since some ketones are carcinogenic, decreased storage stability, and emulsification in certain application methods, such as web offset printing, when aliphatic amines or alkanolamines are used. Another disadvantage of radiation cured ethylenically unsaturated compounds is poor adhesion that is caused by the large amount of shrinkage that occurs during the ethylenic unsaturation polymerization process. Decreasing the amount of ethylenic unsaturation, which is usually present in the form of acrylate functionality, in a coating, ink or adhesive formulation is advantageous in that it will decrease shrinkage and improve adhesion.

## OBJECTIVES OF THE INVENTION

An object of the present invention is to enhance the mechanical property characteristics such as adhesion, flexibility, softness, gloss, toughness, and/or other functional or decorative properties of coatings, inks, adhesives, sealants and fabricated parts.

Another object of the present invention is to significantly decrease the amount of ethylenically unsaturated acrylate used in a given formulation, which acrylates are known to be skin and eye irritants and which can have other undesirable health characteristics.

Yet another object of the present invention is to provide less system polymerization shrinkage and thus improved inherent adhesion in the final cured film or product.

Other objects will become apparent from the specification and examples which follow.

## SUMMARY OF THE INVENTION

This invention provides the use of multifunctional amine compounds as aromatic ketone photosensitizer synergists or cophotosensitizers in photo-curable, ethylenically-unsaturated formulations that are suitable for use as coatings, inks, adhesives, sealants, and fabricated parts. It has now been found that these combinations give excellent rates of photopolymerization when used in systems that involve the photopolymerization of ethylenic double bonds such as those contained in acrylates without exhibiting the disadvantages described above.

Although it is preferred that the amine compounds of this invention be used with aromatic ketone photosensitizers such as benzophenone, chlorothioxanthone, and the like, that function through an intermolecular hydrogen abstraction mechanism, other photoinitiators can be used. In addition, the aromatic ketone photosensitizers can be used alone, in combination with each other, or in combination with photoinitiators that function via a homolytic fragmentation mechanism when used in combination with the amine compounds and photopolymerizable ethylenically unsaturated compounds. The composition can contain various amounts of the amine compounds wherein said amounts will depend on the molecular weight/equivalent weight of said amine compound and on the desired performance requirements of the cured product.

The invention also comprises liquid photoinitiator compositions that are combinations or mixtures of the amine compounds and one or more aromatic ketone photosensitizers and which can optionally contain photoinitiators that operate via a homolytic fragmentation mechanism.

## DETAILED DESCRIPTION OF THE INVENTION

In accordance with the present invention there is provided amines of the general formula:

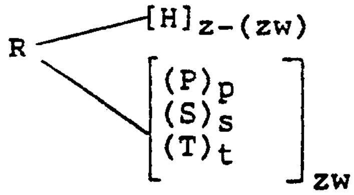

wherein R is an initiator radical based on a compound containing Zerewitinoff active hydrogen atoms and is capable of initiating polymerization with alkylene oxides when used with a suitable catalyst such as potassium hydroxide, zinc hexacyanocobaltate, and the like. It is understood by those skilled in the art that not all of the potential active hydrogen atoms must become activated during the reaction process of making polyols and some of the starting functionality such as hydroxyl may remain on the initiator molecule.

Examples of such compounds that contain Zerewitinoff active hydrogen atoms include but are not limited to difunctional compounds such as ethylene glycol, propylene glycol, water, 1,4-butanediol, diethyleneglycol; trifunctional compounds such as trimethylolpropane, glycerol, trimethylolethane; and other higher functional compounds such as pentaerythritol, sorbitol, sucrose, ammonia, ethylene diamine, 1,3-diaminopropane, 1,6-hexanediamine, isomers of phenylenediamine and toluenediamine, 4,4'-diphenylmethane diamine and its isomers, diethanolamine, ethanolamine, dimethylethanolamine, N-methylethanolamine, triethanolamine, triisopropanolamine, and propylene disulfide.

Additional examples of compounds suitable for initiating polymerization of alkylene oxides are the various oligomeric polyols known in the art. These include the poly(1,4-butylene oxide) polyethers and the hydroxyl- and amine-terminated polybutadienes. When polyols (or other oligomers) are used for initiating polymerization of the alkylene oxides, their molecular weights can range from 400 to 3000 (oligomeric to polymeric). When the conventional initiators such as described above (i.e., glycerine, water, etc.) are used, their molecular weight can range from about 18 up to about 400. Preferably R contains from two to about six carbon atoms.

Examples of R include but are not limited to initiator radicals such as the following:

(1) if R is linear and has three carbon atoms as it would have from glycerol, it would have the structure

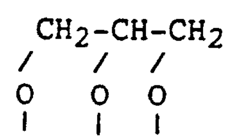

,

(2) if R is branched and has six carbon atoms as it would have from trimethyolpropane, it would have the structure

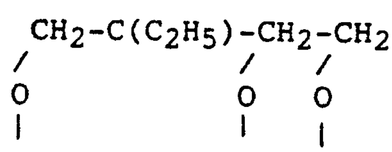

,

and

(3) if R is branched and has 5 carbon atoms as it would have from pentaerythritol and if only three of the active hydrogens had been removed, it would have the following structure

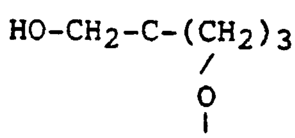

(4) if R is linear and difunctional and is derived from a (tetramethylene oxide)polyol or poly (1,4 butylene oxide) as it would have from the initiation and polymerization of tetrahydrofuran with water, it would have

the structure

$$\lbrack O-(CH_2)_4\rbrack_d-O-(CH_2)_4-O-$$

wherein d can range from zero to fifty with the preferred range four to 35. Hydroxyl terminated poly (tetramethylene oxide) products obtained by the polymerization of tetrahydrofuran, are commercially available as Polymeg™ and Terethane™manufactured by Quaker Chemical Company and Dupont Company wherein the initiator is unknown.

The alkylene oxides and other monomers that find utility in the present invention are those well known in the art. These include ethylene oxide, propylene oxide, the alpha-olefin oxides such as 1,2-epoxybutane, and 1,2-epoxyoctadecane, oxetane, and tetrahydrofuran.

"H" represents a hydroxy-containing group of the formula

$$-(CH_2CH_2-O)_a(CH_2\overset{CH_3}{CH}-O)_b(CH_2\overset{R'}{CH}-O)_c-(CH_2)_n\overset{R''}{CH}-OH;$$

"P" represents a primary amine-containing group of the formula

$$-(CH_2CH_2-O)_a(CH_2\overset{CH_3}{CH}-O)_b(CH_2\overset{R'}{CH}-O)_c-(CH_2)_n\overset{R''}{CH}-NH_2;$$

"S" represents a secondary amine-containing group of the formula

$$-(CH_2CH_2-O)_a(CH_2\overset{CH_3}{CH}-O)_b(CH_2\overset{R'}{CH}-O)_c-(CH_2)_n\overset{R''}{CH}-\overset{R'''}{NH};$$

and "T" represents a tertiary amine-containing group of the formula

$$-(CH_2CH_2-O)_a(CH_2\overset{CH_3}{CH}-O)_b(CH_2\overset{R'}{CH}-O)_c-(CH_2)_n\overset{R''}{CH}-\overset{R''''}{N}R'''$$

wherein:

(1) the letter "a" defines the ethylene oxide content of the amine and can range from a value of zero to 175 with the preferred range being from zero to 90, and, when "b" or "c" is not equal to zero, the most preferred range is from zero to 50,

(2) the letter "b" defines the propylene oxide content of the amine and can also range from a value of zero to 175 with the preferred range being from zero to 115, and the most preferred range from three to 98,

(3) The letter "c" defines the alpha-olefin oxide

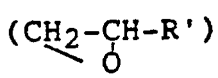

content of the amine and can range from zero to 30 with the preferred range being from zero to 15 and the most preferred range from zero to 2,

(4) and the letter "n" equals an integer equal to from 1 to 3 and preferably 1 or 3.

Ethylene oxide, propylene oxide, alpha-olefin oxide, and tetramethylene oxide, can be incorporated into the product backbone in any sequential manner, i.e., random or block sequence, in any configuration or

conformation.

R' is an alkyl group containing from two carbon atoms to 18 carbon atoms depending on the alpha-olefin oxide used in preparation of the amine. While R' can contain up to 18 carbon atoms, it is most preferred that R' contain two carbon atoms.

R'' is hydrogen or an alkyl group containing from one up to 18 carbon atoms with it preferred that R'' is hydrogen or an alkyl group with up to two carbon atoms and with it most preferred that R'' is hydrogen or a methyl group.

R''' and R'''' are independently an alkyl group containing from two to 12 carbon atoms and preferably containing from two to six carbon atoms.

p is a mole fraction of the primary aminated portion of the amine reactant and is from 0 to 1.0, preferably from 0 to less than 0.75;

s is a mole fraction of the secondary aminated portion of the amine reactant and is from 0 to 1.0, preferably from 0.25 to 1.0;

t is a mole fraction of the tertiary aminated portion of the amine reactant and is from 0 to 1.0, preferably from 0 to 0.2;

w is the percent amination of the Zerwitinoff active hydrogen atoms on the intermediate compound, generally 30 percent to 100 percent, and preferably 70 percent or more; and

(zw) is the product of z and w;

The sum of p, s, and t must equal 1.0.

The letter "z" is an integer equal to the number of Zerewitinoff active hydrogens on the initiator and must be at least two. The letter "z" is preferably 2 to 6.

The above parameters describe amines with equivalent weights ranging from about 100 to 10,000 or more when the functionality is between 2 and 6 but it is preferred that equivalent weights of from 600 to 10,000 or more be used in the practice of this invention.

The amines that are useful in the present invention are prepared by direct, catalytic amination of an appropriate polyol such as

$$R-[(CH_2CH_2-O)_a(CH_2\overset{CH_3}{CH}-O)_b(CH_2\overset{R'}{CH}-O)_c-(CH_2)_n\overset{R''}{CH}-OH]_z$$

with an amine such as $R'''-NH_2$ or R'''-N(H)-R''''. Details of the procedure for preparation of the compounds can be found in copending United States Patent Application Serial Number 176,222 filed on March 31, 1988 and U.S. Patent No. 3,654,370.

The aromatic ketone photosensitizers are those aromatic ketones which act as photosensitizers and in which a ketonic group is attached directly to a carbon present in an aromatic or unsaturated ring. Illustrative of such compounds are benzophenone and benzophenone derivatives, xanthen-9-one, thioxanthone, 2-chlorothioxanthone, isopropylthioxanthones, 2,3-diethylthioxanthone, sodium-4(sulphomethyl)benzyl, (4-benzoylbenzyl)trimethylammonium chloride, sodium-4-(sulphomethyl)benzophenone, fluorenone, benzil, bis-(4,4'-dimethylamino)benzophenone, 4-chlorobenzophenone, 4-phenylbenzophenone, 4-p-tolylthiobenzophenone, 2-methylanthraquinone, dibenzosuberone, biacetyl, dodecylthioxanthenones, 9,10-anthraquinone, camphor quinones, 1,3,5-triacetylbenzene, 3-ketocoumarines, acridone, p-diacetylbenzene, 3-acetylphenanthrene, penanthrenquinone, and the like. Preferably, benzophenone or benzophenone derivatives.

Illustrative of the ethylenically unsaturated monomers suitable for use in the invention are the esters of acrylic and methacrylic acid with monohydric and polyhydric compounds, such as methyl, ethyl, propyl, butyl, pentyl, hexyl, octyl, decyl, and the like acrylates and methacrylates as well as the various isomers of these and other listed compounds, neopentyl diacrylate, esterdiol diacrylates such as 2,2-dimethyl-3-hydroxypropyl-2,2-diemthyl-3-hydroxypropionate diacrylate, trimethylolpropane triacrylate, pentaerythriol di-, tri-, and tetraacrylate, hyroxyethyl acrylate, hydroxypropyl acrylate, caprolactone acrylates, ethoxylated acrylates, propyoxylated acrylates, glycerol acrylates, triethylene glycol diacrylate, tetraethylene glycol diacrylate, ethoxyethyl acrylate, cyclohexyl acrylate, 2-phenoxyethyl acrylate, isobornyl acrylate, 1,3-butylene glycol diacrylate, 1,4-butanediol diacrylate, 1,6-hexanediol diacrylate, glycidyl acrylate, as well as the methacrylates of such compounds, and the like; styrene, divinylbenzene; N-vinylpyrrolidone, and the like. Illustrative of the oligomers or polymers which can be used in the photopolymerizable reaction formulations are poly(ethylene glycol) acrylates, caprolactone di-, tri-, and tetraacrylates, tripropylene glycol diacrylate, poly(propylene glycol) acrylates, ethoxylated or propoxylated Bisphenol A diacrylates, alkoxylated esterdiol diacrylates such as ethoxylated or propoxylated 2,2-dimethyl-3-hydroxypropyl-2,2-dimethyl-3-hydroxypropionate diacrylates, acrylates of caprolactone reacted with esterdiols, ethoxylated or propoxylated trimethylolpropane triacrylate, ethoxylated or propoxylated pentaerythriol di-, tri, or tetracrylate, unsaturated polyesters containing ethylenic unsaturation from maleic, fumaric, citraconic, and the like unsaturated dicarboxylic acids, urethane acrylates of various types, epoxy acrylates, acrylated polybutadiene, acrylated linseed oil, acrylated soyabean oil, and the like. Compounds such as those mentioned are known to those skilled in the art and many are commercially available. Preferably the acrylates are employed, such as monoacrylatjes, diacrylates, triacrylates and acrylates of higher functionality.

The photopolymerization process of this invention is conducted in accordance with procedures conventional in the art with the distinguishing feature being the use as the photoinitiator of a combination of an aromatic ketone photosensitizer and an amine compound. The formulations or systems of this invention which are used in the photopolymerization processes comprise one or more photopolymerizable, ethylenically unsaturated monomers, oligomers, and polymers, one or more amine compounds of the present invention, and one or more photosensitizer or mixture of photosensitizer and photoinitiator. The formulations may also contain a variety of additives including stabilizers such as hydroquinone or methyoxyhydroquinone which prevent premature polymerization during preparation, handling, and storage of the system, antioxidants, surfactants or other flow and leveling agents, fillers, pigments, silane or titanium coupling agents, thickeners, inert solvents, inert polymers, waxes, adhesion promotors, slip agents such as the silicone oils, powdered polytetrafluoroethylene and/or polyethylene, and the like which are known to those skilled in the art of coating formulation some of which are discussed in more detail below

The formulations are applied to appropriate substrates as thin films by a variety of processes illustrative of which are roll coating, dip coating, spray coating, brushing, flexographic, lithographic, and offset web printing processes, and the like.

The photopolymerization is carried out by exposing the film or coating to light radiation which is rich in short-wave radiation. Particularly useful is radiation of about 200 to about 450 nanometers in wavelength. Illustrative of appropriate light sources are low pressure, medium pressure, and high pressure mercury vapor lamps, xenon and other flash-type lamps, fluorescent lights, lasers, electrodeless mercury lamps, and the like. Other sources of radiant energy such as electron beams, gamma radiation, X-rays, sunlight, and so on can also be used.

Usually proper selection of the above formulation ingredients will yield systems that are easily applied. However, in certain cases it may be desirable to reduce the viscosity by adding one or more inert or nonreactive solvents to the systems in amounts of about one to about 25 weight percent for the purpose of improving flow characteristics or for altering other response characteristics. In certain cases, it may be desirable to use more than 25% of the solvent. Illustrative of such solvents are 1,1,1-trichloroethane, butanol, ethanol, ethoxyethanol, ethoxyethyl acetate, ethoxybutanol, ethoxybutanol acetate, butyl acetate, methyl isobutyl ketone, methyl ethyl ketone, methyl amyl ketone, propylene glycol methyl, propyl, and butyl ethers, dipropylene glycol alkyl ethers, and the like. In certain instances it may be desirable to add water or a mixture of water and organic solvent to the coating formulation.

It may also be desirable to thicken certain formulations such as those used for screen printing or other end use requiring special rheological responses. Illustrative of the various inert thickening agents that may be employed are fumed silicas, clays, glass spheres or other microballoons, aluminum trihydrate, polymers such as cellulose acetate butyrate, vinyl polymers, phenoxy, acrylates, and the like. The amount of such materials used in a system is dependent on the desired viscosity, thixotropy, or other flow characteristic and is known by those skilled in the art of formulating coatings, inks, and the like.

Although the components of the formulations are miscible, it may be necessary for times as long as 24 hours or more to elapse under ambient conditions to ensure that a photosensitizer such as benzophenone is well dissolved in the system and that optimum results are obtained. As is known to those skilled in the art of coating formulation such a time is dependent on may factors including formulation components, photosensitizer concentration, temperature, and the like. In special cases, it may be necessary to agitate the system during use to ensure miscibility of all components.

When carrying out the photopolymerizable process or method of the invention, the various components of the system can be brought together in any order using any conventional type of mechanical or manual blending equipment. The aromatic ketone photosensitizer or mixture of aromatic ketone photosensitizers, the amine compound or mixtures of more than one of the amine compounds if desired, and if desired the optional type photoinitiators can be added as separate components to the formulation or they can be preblended and added as a single component. If desired, the mixtures may also contain minor amounts of less than 1 percent to about 2 percent of known synergists such as diethanolamine, triethylamine, or the like. The latter preblending method is sometimes preferred since in many instances all the components of

the system other than the photoinitiator composition may be prepared and stored prior to use and the photoinitiator composition is only added immediately before use. In addition, certain aromatic ketone compounds such as benzophenone are solids and require the passage of time to effect dissolution. Preblending will yield a liquid, easily handled and used mixture that is immediately ready for use. This method avoids any possible instability or reactivity problems which might arise if all the components of the system were mixed and then stored for extended periods before use. As known to those skilled in the art of formulating photocurable acrylate systems, the length of shelf storage is variable and depends on such factors as temperature, presence of light and particularly ultraviolet light, air space in container, and the like.

The amount in which the mixture of components is used in the photopolymerizable systems of the invention can vary over a wide range depending on the nature of the system. Generally, from about 2 to about 65 weight percent o the combination aromatic ketone photosensitizer and multifunctional amine compound is used based on the total weight of the photocurable materials. Preferably, 2 to 50 weight percent. The proportion in which the aromatic ketone photosensitizer is blended with the amine compounds of the invention is broad and depends on the molecular weight/equivalent weight of the compounds. In general the aromatic ketone photosensitizer is present in an amount ranging from about 0.5 to about 15 weight percent based on the total photcurable materials. More preferably from about 1 to about 10 weight percent is used. The photoinitiator composition can optionally contain up to about 75 weight percent of a homolytic fragmentation type photoinitiator based on the weight of the mixture of the aromatic ketone photosensitizer, multifunctional amine compound and homolytic photoinitiator.

As mentioned above, a particular embodiment of the invention comprises certain photoinitiator compositions which are mixtures of one or more aromatic ketone photosensitizer that is capable of participating in intermolecular hydrogen abstraction, one or more of the amine compounds, and optionally a photoinitiator of the homolytic fragmentation type. It has been found that such compositions are usually liquid in nature and can be stored for extended periods preferably in the absence of ultraviolet radiation or other light. If desired or if needed to effect solution of the combined compounds, an inert solvent such as those indicated above can be added to the mixture. The photoinitiator composition may optionally contain from zero to 75% by weight of a homolytic fragmentation type photoinitiator illustrative of which are the benzyl ketals, 2,4,6-trimethylbenzoyldiphenylphosphine oxide, acetophenone and derivatives such as 2,2-diethoxyacetophenone, 2,2-dimethoxy-2-phenylacetophenone, 2-hydroxy-2,2-dimethylacetophenone, and the like, 1-benzoyl-cyclohexan-1-ol, benzoin, alkyl benzoin ethers such as methyl, ethyl, isopropyl, n-butyl, isobutyl benzoin ethers, and the like. If desired, the photoinitiator compositions can contain from 1 to about 25% by weight of an inert solvent such as those described above. Particularly preferred photoinitiator compositions comprise mixtures of benzophenone and one or more amine compounds of the present invention.

The compositions of the invention can be exposed to radiation in a variety of atmospheres illustrative of which are air, nitrogen, argon and the like. It has been found that the coatings do not require an inert atmosphere for cure and either an active or oxygen-containing atmosphere such as air or an inert atmosphere such as nitrogen can be used.

The use of the compositions or the photoinitiator compositions of the invention gives excellent results in terms of adhesion to a variety of substrates, of rapidity with which cure of the photopolymerizable systems can be effected, in terms of surface finish which may be clear and glossy or matte in appearance, of absence of yellowing, of excellence of mechanical properties when applied in film form as well as low odor systems. In addition, if the photoinitiator compositions are preblended before use, they offer a marked advantage in ease of handling and use. In addition, it has been found that the photoinitiator combinations of the invention can be stored alone or in admixture with the other components of the photopolymerizable systems for substantial periods (four months or more) without showing any signs of instability or being changed in any way in terms of their ability to cure the system on exposure to appropriate radiation.

The compositions of this invention are useful in a variety of end uses. Illustrative of these end uses are general metal coatings for steel, tin plated steel, tin-free steel, galvanized steel, phosphatized or other treated steel, aluminum, copper, tin-lead solders, as well as other metals, appliance coatings, business machine coatings, office equipment coatings, lamp and lighting fixture coatings, beverage and other can coatings, decorative coatings, overprint varnishes, inks, sealants, adhesives, coatings for electronics such as laser markable coatings, conformal coatings, photoresists, solder masks or resists, coatings for optical discs and compact discs, coatings for magnetic tape, coatings for optical fibers, coatings for glass fiber-reinforced polyester materials, coatings for glass or carbon fiber-reinforced composites prepared from unsaturated polyesters and styrene, coatings for sputtered or vapor deposited aluminum, gold or other metals, graphite or carbon fiber reinforced laminates/composites, coatings for glass, wood, plastics such as polyesters, polycarbonate, polysulfone, treated polyethylene and polypropylene, and shaped products such as those prepared using stereo lithography and the like.

Whereas the exact scope of the instant invention is set forth in the appended claims, the following specific examples illustrate certain aspects of the present invention and, more particularly, point out methods of evaluating the same. However, the examples are set forth for illustration only and are not to be construed as limitations on the present invention except as set forth in the appended claims. All parts and percentages are by weight unless otherwise specified.

The coating compositions prepared in the examples below were evaluated according to the following procedures.

Solvent Resistance (Double Acetone Rubs): A measure of the resistance of the cured film to attack by acetone in which a film coating surface was rubbed with an acetone- soaked cloth back and forth with hand pressure. A rub back and forth over the film coating surface with the acetone soaked cheesecloth was designated as one "double acetone rub." The effect that a certain number of double acetone rubs had on the film coating surface was reported by a number in parenthesis following the number of double acetone rubs. The rating system for evaluating acetone resistance for a given number of double acetone rubs was as follows:

Number in Parenthesis After Number of Rubs

(1) No change in coating appearance
(2) Surface scratched
(3) Surface dulled or marred. some coating removed
(4) Breaks in coating apparent
(5) About 50% or more of coating removed

Pencil Hardness: Pencil leads of increasing hardness values were forced against the film coating surface in a precisely defined manner as described in ASTM D3363-74 until one pencil lead cut through the surface of the film coating. The surface hardness was considered as the hardest pencil grade which just failed to cut or mar the film coating surface. The pencil leads in order of softest to hardest were reported as follows: 6B, 5B, 4B, 3B, 2B, B, HB, F, H, 2H, 3H, 4H, 5H, 6H, 7H, 8H, AND 9H.

Crosshatch Adhesion. A lattice pattern with ten cuts in each direction was made in the coating film to the substrate and pressure-sensitive adhesive tape (Scotch Brand 606) was applied over the scored/cut substrate and then quickly removed as prescribed in ASTM D3359-78. The adhesion was evaluated by comparison with descriptions and illustrations as more fully detailed in the cited method. A rating of 5B indicates excellent adhesion with nil removal.

Gardner Impact Resistance. A measure of the ability of a cured film coating on a substrate to resist rupture from a falling weight. A Model IG-1120 Gardner Impact Tester equipped with an eight-pound dart was used to test film coatings cast and cured on steel panels. The dart was raised to a given height in inches and dropped onto either the coated side of the coated steel panel (direct or forward impact resistance) or the uncoated side of the coated steel panel (reverse impact resistance). The height-of-drop in inches times weight of dart (8 pounds), designated as inch-pounds, absorbed by the film without rupturing was recorded as the films direct or reverse impact resistance.

Gloss. Gloss measurements were made at either 20 degrees and/or 60 degrees in accordance with ASTM D523-78 using a Gardner gloss meter equipped with 20 and 60 degree heads.

GLOSSARY

TMPTA is trimethylolpropane triacrylate.

Epoxy Acrylate I is an acrylated epoxide with a viscosity of about 1,000,000 cp at 25°C marketed by Sartomer under the designation Epoxy Diacrylate C-3000.

Urethane Acrylate I is an acrylated urethane with a viscosity of 167,000 cp at 70°F marketed by Sartomer under the designation Urethane Diacrylate (Medium) C-9504.

Surfactant I is a silicone/alkylene oxide copolymer marketed by Union Carbide Corp. under the designation L-7610.

Surfactant II is a silicone/alkylene oxide copolymer marketed by Union Carbide Corp. under the designation L-5420.

Photosensitizer A is a 50/50 mixture of benzophenone and 1-hydroxycyclohexylphenyl ketone which is marketed by Ciba-Geigy as IRGACURE™ 500.

Photoinitiator A is 1-hydroxycyclohexylphenyl ketone and is marketed by Ciba-Geigy as IRGACURE™184.

Photoinitiator B is 2,2-diethoxyacetophenone that is marketed by Upjohn as DEAP.

Polyamine I is a triamine-functional, propylene oxide compound with an equivalent weight of about 2169 and an amine number of about 0.461 meq/g. It contains about 73% primary amine end groups, about 20-25% secondary amine end groups, and 0 to 5% tertiary amine end groups. If all end groups in a given molecule were primary, it would have the following average structure.

```
                 CH3                CH3
                 /                  /
CH2-O[CH2CH-O]36-(CH2)CH-NH2
/
/          CH3                CH3
/          /                  /
CH-O[CH2CH-O]36-(CH2)CH-NH2
/
/           CH3                CH3
/           /                  /
CH2-O[CH2CH-O]36-(CH2)CH-NH2
```

Polyamine II is a tri-secondary-amine functional, propylene oxide compound that has an average equivalant weight of about 2110 and an average amine number of about 0.474 meq/g. It contains about 73% secondary amine groups and about 25% primary and/or tertiary amine end groups. If all end groups were secondary in a given molecule, it would have the following average structure.

```
             CH3                CH3H
             /                  /  /
CH2-O[CH2CH-O]35-(CH2)CH-N-CH(CH3)2
/
/          CH3                CH3H
/          /                  /  /
CH-O[CH2CH-O]35-(CH2)CH-N-CH(CH3)2
/
/            CH3                CH3H
/            /                  /  /
CH2-O[CH2CH-O]35-(CH2)CH-N-CH(CH3)2
```

Polyamine III is a commercial, 100% primary amine terminated, propylene oxide compound with an average equivalent weight of 1818, an amine number of 0.55 meq/g. It is available from Texaco Corporation under the designation T-5000.

Polyamine IV is a tri-secondaryamine functional, propylene oxide compound that has an average equivalant weight of 2160 and an average amine number of 0.463 meq/g. It contains about about 92.5% secondary amine groups and about 7.5% primary and/or tertiary amine end groups. If all end groups were secondary in a given molecule, it would have a structure similar to that depicted for Polyamine II above.

Polyamine V is a tri-tertiaryamine functional propylene oxide compound with a combined tertiary and secondary amine content of about 92%, and a primary amine content of about 8%. It has an amine number of 0.484 meq/g and an equivalent weight of 2066.

Polyamine VI is a tri-secondaryamine functional, propylene oxide compound that has an average equivalant weight of 984 and an average amine number of 1.016 meq/g. It contains about about 8% primary amine groups and about 92% combined secondary and tertiary amine groups. If all end groups were secondary in a given molecule, it would have a structure similar to that depicted for Polyamine II above.

Amine Synergist A is N-methyldiethanolamine which has a molecular weight of 121.

Amine Synergist B is 2-ethylhexyl-p-N,N-dimethyl-aminobenzoate,

$(CH_3)_2N\text{-}C_6H_4\text{-}COO\text{-}CH_2\text{-}CH(C_2H_5)\text{-}(CH_2)_3\text{-}CH_3$,

with a molecular weight of 277. It is marketed by Ciba-Geigy under the designation UVATONE™ 8308.

Polyol I is a trifunctional propylene oxide polyol made from a glycerine starter with an average equivalent weight of 2003 and an average hydroxyl number of 28.

Control Examples A and B and Examples 1 and 2. The following ingredients were placed in glass bottles and well mixed to form coating formulations. They were then coated onto Bonderite 37 steel panels

with a No. 15 wire-wound rod and cured in an air atmosphere unless (as noted below) trimethylol propane triacrylate, TMPTA, was being cured alone as in the controls. Since it is well known that all acrylate systems are inhibited by the oxygen present in an air curing environment, a nitrogen atmosphere was used to cure Control A and B and thus giving them a more favorable environment than used used for the other examples. Control C is a formulation that contains TMPTA and the polyol that was used to prepare Polyamine I. The formulated systems were exposed at a distance of about 5.5 inches from a stationary, 4-inch long, 100 watt per inch medium pressure mercury vapor lamp for the indicated times.

| | Example | | | |
|---|---|---|---|---|
| Ingredients, g | Control A | Control B | Control C | 1 |
| Polyamine I | ---- | ---- | ---- | 4.90 |
| Polyol I | ---- | ---- | 4.90 | ---- |
| TMPTA | 9.90 | 9.90 | 5.00 | 5.00 |
| Benzophenone | 0.10 | 0.30 | 0.10 | 0.10 |
| UV Exposure Time, minutes | 5 | 5 | 3 | 3 |

| Test Results | | | | |
|---|---|---|---|---|
| Double Acetone Rubs | No Properties were | No Properties were | * | 50 (2) |
| Pencil Hardness | determined. | determined. | <6B | 5B |
| Crosshatch Adhesion | System did not cure, | System did not cure, | 5B | 5B |
| Gardner Impact, | did not become | did not become | | |
| Forward, in lbs | solid in | solid in | 25 | 38 |
| Reverse, in lbs | the exposure time used. | the exposure time used. | <5 | <5 |

* System had a portion of the coating removed after 50 double rubs and after the rubbing had ceased and the acetone evaporated, the remaining coating blistered and could be easily removed from the substrate by very gentle hand rubbing. After standing at room temperture for a few days, untested coating have a greasy "bloom" which suggests unreacted polyol is exuding to the surface of the coating.

Control Examples A and B demonstrate that TMPTA alone remains liquid and would not cure, i.e. crosslink, during the exposure time when an intermolecular hydrogen abstraction-type photosensitizer such as benzophenone is used. In the presense of an alpha hydrogen source, such as a polyol or an amine, cure does take place as demonstrated with Control C and in Example 1. However, in the case of the polyol, which is the polyol used to prepare the amine compound used in Example 1, the polyol does not cure into the system to any appreciable degree as evidenced by the poor solvent reistance and the later "bloom" on

the surface. In contrast, when Polyamine I is used a useful coating with good solvent resistance--the coating is only scratched by the rubbing cloth after 50 double acetone rubs--and no evidence of bloom is obtained, indicating reaction of the amine compound and the acrylate has taken place and a soft, but useful coating with good solvent resistance and adhesion has resulted.

Examples 2-4. The following ingredients were placed in glass containers, well mixed and coated onto Bonderite 37 steel panels with a No. 15 wire wound rod. The coatings were exposed for the indicated times to the same ultraviolet light source as was used for Example 1 in an air atmosphere.

| | Example | | |
|---|---|---|---|
| Ingredients, g | 2 | 3 | 4 |
| Polyamine I | 4.9 | --- | --- |
| Polyamine II | --- | 4.9 | --- |
| Polyamine III | --- | --- | 4.9 |
| TMPTA | 5.0 | 5.0 | 5.0 |
| Benzophenone | 0.1 | 0.1 | 0.1 |
| Exposure Time, Min. | 3 | 3 | 3 |
| Test Results | | | |
| Double Acetone Rubs | 100 (1) | 100 (1) | 100 (1) |
| Pencil Hardness | F | 4B | HB |
| Crosshatch Adhesion | 5B | 5B | 4B |

These results indicate that both primary amine-terminated propylene oxide compounds and secondary amine-terminated propylene oxide compounds can be used in conjunction with photosensitizers that are said to function through an intermolecular hydrogen abstraction mechanism to form useful coatings. The coating of Example 2 is a reformulation of the system used for Example 1. The results of Example 2 are superior to those of Example 1.

Example 5. Polyamine I (9.9 g) and benzophenone (0.3 g) were placed in a glass container and well mixed. After dissolution of the photosensitizer, the mixture was coated onto Bonderite 37 steel panels with a No. 15 wire-wound rod and cured under the same ultraviolet light source as was used in Example 2 using an air atmosphere. After 15 minutes exposure the system remained liquid with no apparent viscosity increase indicating no reaction had taken place. This example points out that the polyamines do not polymerize in the presence of free radical generating photosensitizers and that only when combined with acrylates does polymerization take place.

Examples 6-9. The following ingredients were placed in glass containers and well mixed. They were then coated onto Bonderite 37 steel panels with a No. 15 wire-wound rod and exposed in an air atmosphere to the same ultraviolet light source as used for Example 2 for the indicated times.

| Ingredients, g | Example 6 | 7 | 8 | 9 |
|---|---|---|---|---|
| Polyamine I | 5.0 | 5.0 | 5.0 | 5.0 |
| TMPTA | 5.0 | 5.0 | 5.0 | 5.0 |
| Benzophenone | 0.1 | --- | --- | --- |
| Photosensitizer A | --- | 0.1 | --- | --- |
| Photoinitiator A | --- | --- | 0.1 | --- |
| Photoinitiator B | --- | --- | --- | 0.1 |
| Exposure Time, min. | 3 | 3 | 5* | 15* |
| Test Results | | | | |
| Double Acetone Rubs | 100 (1) | 100 (1) | <50 (5) | <50 (5) |
| Pencil Hardness | F | <4B | <6B | <6B |
| Crosshatch Adhesion | 5B | 5B | 2B | 4B |

* The coating of Example 8 was tacky after exposure, but it was tested in this form. It was assumed that the tacky condition is related to poor surface cure that was obtained when the homolytic fragmentation type photoinitiator was used. Coating of Example 9 was tacky after 6 minutes exposure due to the reason previously mentioned. It was allowed to remain under the ultraviolet light source for a total of 15 minutes to ascertain if further cure was obtained and then tested.

These examples demonstrate that benzophenone and other intermolecular hydrogen abstraction-mechanism type photosensitizers are preferred (Example 6), that mixtures of such photosensitizers and homolytic fragmentation type photoinitiators can be used (Example 7), and that homolytic fragmentation type photoinitiators can be used but relatively long radiation times and less satisfactory results are obtained (Examples 8 and 9).

Examples 10-13. The following ingredients were combined in glass containers and well mixed. After the photosensitizer and photoinitiators had dissolved, the formulations were coated onto Bonderite 37 steel panels with a No. 15 wire-wound rod and exposed in an air atmosphere to the same ultraviolet light source used for Example 2.

| | Example | | | |
|---|---|---|---|---|
| Ingredients, g | 10 | 11 | 12 | 13 |
| Polyamine III | 5.0 | 5.0 | 5.0 | 5.0 |
| TMPTA | 5.0 | 5.0 | 5.0 | 5.0 |
| Benzophenone | 0.1 | --- | --- | --- |
| Photosensitizer A | --- | 0.1 | --- | --- |
| Photoinitiator A | --- | --- | 0.1 | --- |
| Photoinitiator B | --- | --- | --- | 0.1 |
| Exposure Time, min. | 3 | 3 | 4* | 4* |
| Test Results | | | | |
| Double Acetone Rubs | 100 (2) | 100 (2) | 100 (5) | 50 (5) |
| Pencil Hardness | F | 2B | <6B | <6B |
| Crosshatch Adhesion | 4B | 3B | 2B | 5B |

* The coatings remained tacky after this exposure period, but curing was terminated since comparisons were being made.

These results, which are for systems similar to Examples 6-9 except that a different polyamine was used, are similar to those obtained in Examples 6-9. The formulations containing the intermolecular hydrogen abstraction photosensitizers (Ex. 10 and 11) functioned well and gave tackfree coatings with good properties. The formulations containing the homolytic fragmentation type photoinitiators did not cure as well (Examples 12 and 13) and gave useful, but less desireable properties. The coatings of these examples were dull in appearance and had a matte finish which indicates that certain systems of this invention have the desireable characteristic of enabling gloss control.

Examples 14-16. In the following examples, five grams of Polyamine I and five grams of TMPTA were combined in glass containers. To these mixtures, the below indicated amounts of benzophenone photosensitizer were added.

Example 14....0.1 g (1.0 wt. percent)
Example 15....0.2 g (2.0 wt. percent)
Example 16....0.4 g (3.8 wt. percent)
Example 17....0.8 g (7.4 wt. percent)

The combinations were well mixed; and after the photosensitizer had dissolved, the systems were coated onto Bonderite 37 steel substrate with a number 15 wire-wound rod and exposed in an air atmosphere to the ultraviolet light source described in Example 2 for a time of four minutes. The cured coatings all had a pencil hardness rating of "B" and a crosshatch adhesion rating of "5B." The coatings of Examples 14 and 15 were unaffected by acetone and had a rating of "100 (1) acetone double rubs." The coatings of Examples 16 and 17 had the surface of the coating slightly scratched or marred by 100 acetone double rubs and had a rating of "100 (2) acetone double rubs." These results indicate that a broad amount of photosensitizer can be used in the coating formulations.

Example 18. This example demonstrates that the coating combinations of this invention can be used as photoresists, solder masks, decorated mirrors, and similar articles of commerce produced by masking techniques. Five grams of Polyamine I and 5 grams of TMPTA and 0.1 gram of benzophenone were placed in a glass container and well mixed to ensure dissolution. They were then applied to a Bonderite 37 steel panel with a No. 15 wire-wound rod. A portion of the wet, uncured coating was then covered or masked with an opaque, dendritic-shaped mask to simulate the type mask used in photoresist applications. The coated, masked panel was then exposed to the ultraviolet light radiation source described in Example 2 for three minutes in an air atmosphere. After exposure the masks were removed. The coating that was under the mask and that did not "see" the ultraviolet light radiation was liquid in nature whereas the coating that was not under the mask and that was exposed to the ultraviolet light was tack free and solid in nature. The panels were then washed with acetone and the liquid coating was removed without affecting the solid coating leaving the mask area free of coating and available for copper plating, silver electrodeposition, or other subsequent operation. The solid or cured coating had the following properties.

Double acetone rubs..........100 (1)
Pencil hardness..............F
Crosshatch Adhesion..........5B
Film appearance..............High gloss

Another Bonderite 37 steel panel and a flame retarded epoxy/fiberglass FR-4 board of the type used for printed circuit boards were coated with the above described formulation using a conventional air-spray coating technique. The liquid coating was masked as described above and exposed to a medium pressure mercury vapor ultraviolet light source as described above. After exposure, the mask was removed and the coating was washed with a dilute (2%) aqueous hydrochloric acid solution to remove the wet, unexposed, uncured coating. The uncured material was removed, the panel and the board were rinsed with distilled water and with isopropanol, and dried leaving the solid, cured coating unaltered and the area of wet-coating-removal free for subsequent copper plating, silver electrodeposition, or the like.

Example 19. This example demonstrates the use of a surfactant in the coating system to improve flow and leveling. Five grams of Polyamine I, five grams of TMPTA, 0.3 gram of benzophenone, and 0.1 gram of Surfactant I were placed in a glass container and well mixed. After the photosensitizer had dissolved, the combination of ingredients was coated onto a Bonderite 37 steel panel with a No. 22 wire-wound rod and exposed in an air atmosphere for three minutes to the same ultraviolet light source as was used for Example 2. The cured coating had the following properties.

Double acetone rubs..............100 (1)
Pencil hardness..................2B
Crosshatch adhesion..............5B
Film appearance..................Smooth, high gloss

Examples 20 to 26. These examples compare the effect of polyamine synergist compounds and low molecular weight, commercial amine synergists in effecting the ultraviolet light cure of acrylates. The amount of synergist used was approximately 0.0023 milliequivalents in all cases. The following ingredients were placed in glass bottles and well blended. After the photosensitizer had dissolved, the combinations

were coated onto Bonderite 37 steel panels with a No. 15 wire-wound rod and exposed for three minutes in an air atmosphere to the same ultraviolet light source used in Example 2. After exposure the cured coatings were tested.

| | Example | | | | | | |
|---|---|---|---|---|---|---|---|
| Ingredients, g | 20 | 21 | 22 | 23 | 24 | 25 | 26 |
| Polyamine I | 5.0 | --- | --- | --- | --- | --- | --- |
| Polyamine II | --- | 5.0 | --- | --- | --- | --- | --- |
| Polyamine III | --- | --- | 5.0 | --- | --- | --- | --- |
| Polyamine IV | --- | --- | --- | 5.0 | --- | --- | --- |
| Polyamine V | --- | --- | --- | --- | 5.0 | --- | --- |
| Amine Synergist A | --- | --- | --- | --- | --- | 0.274 | --- |
| Amine Synergist B | --- | --- | --- | --- | --- | --- | 0.64 |
| TMPTA | 5.0 | 5.0 | 5.0 | 5.0 | 5.0 | 5.0 | 5.0 |
| Benzophenone | 0.1 | 0.1 | 0.1 | 0.1 | 0.1 | 0.1 | 0.1 |
| Test Results | | | | | | | |
| Double AcetoneRubs | 100 (1) | 100 (1) | 100 (1) | 100 (2) | 100 (2) | * | 100 (1) |
| Pencil Hardness | F | 2B | F | 6B | 6B | * | 4H |
| Crosshatch Adhesion | 4B | 5B | 2B | 5B | 5B | * | 0B |
| Film Appearance** | T | T | T | T | T | * | Y |

* Coating was very poor in character and flaked off the panel. It was not possible to conduct testing.

** T = transparent, clear, no appearance of color
Y = transparent, rough, yellow

The results indicate that the combinations containing the polyamine synergists and a multifunctional acrylate produced good, useful coatings that had good solvent resistance and adhesion while increasing flexibility/softness over that obtained with TMPTA alone. The combinations containing low molecular weight, commercial amine synergists and multifunctional acrylates resulted in coatings either with complete failure (Example 25) or with poor adhesion and yellowing (Example 26).

Examples 27 to 31. These examples point out that the polyamine-containing compositions of this invention encompass a variety of acrylate ingredients. The following ingredients were placed in glass containers and well mixed. After the photoinitiator was dissolved, the formulations were coated onto Bonderite 37 steel panels with a No. 15 wire-wound rod. The coated panels were exposed for six minutes, an arbitary time period, in an air atmosphere to the same ultraviolet light source as was used for Example 2. The cured panels were then evaluated.

| | Example | | | | |
|---|---|---|---|---|---|
| Ingredients, g | 27 | 28 | 29 | 30 | 31 |
| Polyamine I | 2.0 | 2.0 | 4.0 | 4.0 | 2.0 |
| TMPTA | 4.0 | 4.0 | 3.0 | 3.0 | 4.0 |
| Urethane Acrylate I | --- | 4.0 | 3.0 | --- | --- |
| Epoxy Acrylate I | 4.0 | --- | --- | 3.0 | 4.0 |
| Benzophenone | 0.1 | 0.1 | 0.1 | 0.1 | 0.1 |
| Surfactant II | --- | 0.1 | 0.1 | 0.1 | 0.1 |
| Test Results | | | | | |
| Double Acetone Rubs | 100 (1) | 100 (1) | 100 (1) | 100 (1) | 100 (1) |
| Pencil Hardness | 2H | F | 5B | H | 4H |
| Crosshatch Adhesion | 4B | 3B | 5B | 5B | 4B |
| Appearance* | HG | M | M | SG | M |

* HG = High Gloss; M = matte finish; SG = semigloss finish

The results show that various acrylates can be combined and used in compositions of this invention to form coatings useful for a variety of end uses.

Examples 32 to 36. These examples demonstrate that compositions of this invention can be cured with different ultraviolet light sources, in different atmospheres (air or nitrogen), and at different cure speeds (conveyor speeds). The following are definitions of the ultraviolet light sources used in these experiments.

Cure Unit I. A commercial PS 7001 ultraviolet light photocure system that is marketed by Photocure Systems of Union Carbide Corp. It is equipped with a conveyor system (maximum cure speed achievable was 68 fpm), a nitrogen delivery system that can produce a variety of nitrogen atmospheres or that can be turned off and allow an air atmosphere to be used, and 100 watt-per-inch, unfocused, medium-pressure mercury-vapor lamps to produce the ultraviolet radiation conditions. The unit was also equipped with two low intensity, ultraviolet light-producing germicidal lamps that could be used for preferential surface cure before entering the above described ultraviolet light atmosphere and that could be in either an "ON" or an "OFF" status. Cure Unit I denotes an ultraviolet light cure system with these lamps in an "OFF" status. The

unit was further equipped with an ancillary 300 watt per inch, focused ultraviolet light lamp that could be in either an "ON" or an "OFF" status. Cure Unit I denotes an ultraviolet light cure system with this lamp in an "OFF" status.

Cure Unit II is the same as Cure Unit I except the two germicidal lamps were in an "ON" status.

Cure Unit III was an ultraviolet light cure system that involved only the conveyor system and the focused, 300 watt per inch ultraviolet light lamp of Cure Unit I in an "ON" status.

Fifty grams of Polyamine I, 50 g of TMPTA, and 3 g of benzophenone were placed in a glass container and well mixed. With the benzophenone dissolved, the combination of coating ingredients were coated with a No. 15 wire-wound rod onto either Bonderite 37 steel (B-37) or on unwaxed, uncoated vinyl tile such of the type used to manufacture home/industrial flooring (Vinyl Tile). The liquid coatings were then exposed to ultraviolet light and cured in the manner described below. The cured coatings were tested using the methods described above.

| | Example | | | | |
|---|---|---|---|---|---|
| | 32 | 33 | 34 | 35 | 36 |
| UV Cure System | | | | | |
| Cure Unit I | Used | Used | ---- | ---- | ---- |
| Cure Unit II | ---- | Used | ---- | ---- | ---- |
| Cure Unit III | ---- | ---- | Used | Used | Used |
| Cure Atmosphere | | | | | |
| Nitrogen ($ft^3$/hr/ lineal ft of conveyor belt width) | Used (100) | Used (300) | ---- ---- | ---- ---- | ---- ---- |
| Air | ---- | ---- | Used | Used | Used |
| Substrate | B-37 | B-37 | B-37 | B-37 | Vinyl Tile |
| Cure Rate | | | | | |
| Conveyor Speed, feet/minute | 30 | 10 | 30 | 68 | 60 |
| Test Results | | | | | |
| Double Acetone Rubs | 50 (5) | 100 (1) | 100 (4) | 100 (5) | ---- |
| Pencil Hardness | 2B | 2B | 2B | 2B | 2B |
| Crosshatch Adh. | 2B | 4B | 5B | 5B | 5B |
| Gloss | | | | | |
| 20 Degree | 73 | -- | 70 | 63 | 43 |
| 60 Degree | 84 | -- | 80 | 80 | 75 |
| Surface Appearance* | SG | T | SG | SG | SG |

* SG = Smooth and Glossy; T = Textured

These examples point out that the compositions of this invention can be cured by various ultraviolet light sources, that useful coatings for different substrates can be obtained, that high rates of cure can be achieved, and that textured coatings can be obtained when preferential surface cure or germicidal lamps are employed.

Example 37. Five grams of TMPTA, 2.43 g of Polyamine VI, and 0.1 g of benzophenone were placed in a glass container and well mixed. After dissolution of the photoinitiator, the photocurable composition was coated onto a Bonderite 37 steel panel with a No. 22 wire-wound rod and exposed in an air atmosphere to

the same light source as used for Example 2 for three minutes. The resulting cured film was hard and could not be scratched with a fingernail and would have utility as an overprint varnish.

Examples 38 and 39. These examples demonstrate that when amine-terminated oxypropylene molecules that have a molecular weight less than that required by this invention are combined with acrylates, unstable systems with short pot lives result. The following ingredients were placed in glass bottles, mixed well, and observed.

| Ingredient, g | Example 38 | Example 39 |
|---|---|---|
| Amine T-403* | 5.0 | 5.0 |
| Trimethylolpropane triacrylate | 5.0 | 3.7 |

*Amine T-403 is a commercial 400 molecular weight, trifunctional, primary amine-terminated oxypropylene compound that is marketed by Texaco as Jeffamine T-403.

When first mixed, the combined materials were warm to the touch. After about four hours, the systems had undergone a definite viscosity increase. About eight hours after mixing the viscosity of the mixtures had increased to the point where they would barely flow. After about 18 to 24 hours, both mixtures were intractable solids. Thus, such systems containing low molecular weight primary amine compounds have only very limited pot life and utility.

## Claims

1. A photocurable composition comprising:
   i) an aromatic ketone photosensitizer,
   ii) a multifunctional amine compound of the formula

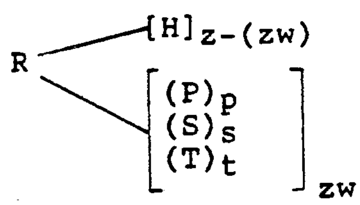

where R is an initiator radical based on a compound containing Zerewitinoff active hydrogen atoms and contains from two to six carbon atoms, H is a hydroxy-containing group of the formula:

$$\begin{array}{l} \qquad\qquad\quad CH_3 \qquad\qquad\quad R' \qquad\qquad\qquad R'' \\ \qquad\qquad\quad / \qquad\qquad\qquad / \qquad\qquad\qquad\; / \\ -(CH_2CH_2\text{-}O)_a(CH_2CH\text{-}O)_b(CH_2CH\text{-}O)_{cd}\text{-}(CH_2)_nCH\text{-}OH, \end{array}$$

P is a primary amine-containing group of the formula:

$$\begin{array}{l} \qquad\qquad\quad CH_3 \qquad\qquad\quad R' \qquad\qquad\qquad R'' \\ \qquad\qquad\quad / \qquad\qquad\qquad / \qquad\qquad\qquad\; / \\ -(CH_2CH_2\text{-}O)_a(CH_2CH\text{-}O)_b(CH_2CH\text{-}O)_c\text{-}(CH_2)_nCH\text{-}NH_2, \end{array}$$

S is a secondary amine-containing group of the formula:

$$-(CH_2CH_2\text{-}O)_a(CH_2\overset{\overset{CH_3}{/}}{C}H\text{-}O)_b(CH_2\overset{\overset{R'}{/}}{C}H\text{-}O)_c\text{-}(CH_2)_n\overset{\overset{R''}{/}}{C}H\text{-}\overset{\overset{R'''}{/}}{N}H,$$

T is a tertiary amine-containing group of the formula:

$$-(CH_2CH_2\text{-}O)_a(CH_2\overset{\overset{CH_3}{/}}{C}H\text{-}O)_b(CH_2\overset{\overset{R'}{/}}{C}H\text{-}O)_c\text{-}(CH_2)_n\overset{\overset{R''}{/}}{C}H\text{-}\overset{\overset{R''''}{/}}{N}R''',$$

wherein a has a value of from zero to 175, b has a value of zero to 175, c has a value of zero to 30, n is an integer of from 1 to 3, R' is an alkyl group of 2 to 18 carbons, R" is hydrogen or an alkyl group of one to 18 carbon atoms, R"' and R"" are independently an alkyl group of 2 to 12 carbon atoms, p is a mole fraction and ranges from zero to 1.0, s a mole fraction and ranges from zero to 1.0, t is a mole fraction and ranges from zero to 1.0, the quantity (p + s + t) equals one, w is the percent amination and ranges from 0.3 to 1.0, z is an integer from 2 to six and (zw) is the product of z and w, and

iii) an ethylenically unsaturated compounds that will undergo photopolymerization.

**2.** The photocurable composition of Claim 1 wherein a is from zero to 90, b is from zero to 115, c is from zero to 15, R' is an ethyl group, R" is hydrogen or a methyl or ethyl group, and R"' and R"" contain from two to six carbon atoms.

**3.** The photocurable composition of Claim 2 wherein a is from zero to 50, b is from 3 to 98, c is from zero to 2, n is one.

**4.** The photocurable composition of Claim 1 wherein t is from zero to 0.2.

**5.** The photocurable composition of Claim 1 wherein a and c equal zero, b is 30 to 40, z equals 3, n equals one, and R" is methyl.

**6.** The photocurable composition of Claim 5 wherein p equals 0.65 to 1.0, s equals zero to 0.30, t equals zero to 0.05.

**7.** The photocurable composition of Claim 5 wherein p plus t equals zero to 0.30, 5 equals 0.70 to 1.0.

**8.** The photocurable composition of Claim 5 wherein R"' is isopropyl.

**9.** The photocurable composition of Claim 1 wherein R is $[0\text{-}(CH_2)_4]_d\text{-}0\text{-}(CH_2)_4\text{-}0\text{-}$ wherein d is from 0 to 50, a, b, and c equal zero, z equals 2, n equals 3, and R" is hydrogen.

**10.** The photocurable composition of Claim 9 wherein d is from 4 to 35.

**11.** The photocurable composition of Claim 1 wherein the aromatic ketone photosensitizer is benzophenone.

**12.** The photocurable composition of Claim 1 wherein the aromatic ketone photosensitizer is a mixture of benzophenone and isopropylthioxanthone.

**13.** The photocurable composition of Claim 1 which also contains one or more photoinitiators of the homolytic fragmentation type.

**14.** The photocurable composition of Claim 13 wherein the photoinitiator is 1-hydroxycyclohexylphenyl

ketone.

**15.** The photocurable composition of Claim 13 wherein the photoinitiator is 2,2-diethoxyacetophenone.

**16.** The photocurable composition of Claim 11 wherein the photocurable composition also contains 1-hydroxycyclohexylphenyl ketone as a photoinitiator.

**17.** The photocurable composition of Claim 1 wherein the ethylenically unsaturated compound is selected from the group consisting of monoacrylates, diacrylates, triacrylates and higher functionality acrylates.

**18.** The photocurable composition of Claim 17 wherein the acrylate is trimethylolpropane triacrylate.

**19.** The photocurable composition of Claim 17 wherein the acrylate is an urethane acrylate.

**20.** The photocurable composition of Claim 17 wherein the acrylate is an epoxy acrylate.

**21.** The photocurable composition of Claim 17 wherein the acrylate is a mixture of trimethylolpropane triacrylate and an epoxy acrylate.

**22.** The photocurable composition of Claim 17 wherein the acrylate is a mixture of trimethylolpropane triacrylate and an urethane acrylate.

**23.** A liquid photoinitiator composition which comprises from about one to about 75 percent by weight of an aromatic ketone photosensitizer and from about 25 to 99 percent by weight of a multifunctional amine compound of the formula:

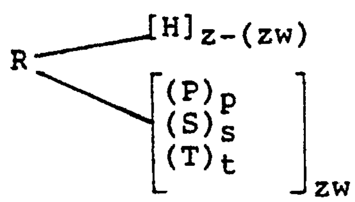

where R is an initiator radical based on a compound containing Zerewitinoff active hydrogen atoms and contains from two to six carbon atoms, H is a hydroxy-containing group of the formula:

$$-(CH_2CH_2-O)_a(CH_2\overset{CH_3}{CH}-O)_b(CH_2\overset{R'}{CH}-O)_{cd}-(CH_2)_n\overset{R''}{CH}-OH,$$

P is a primary amine-containing group of the formula:

$$-(CH_2CH_2-O)_a(CH_2\overset{CH_3}{CH}-O)_b(CH_2\overset{R'}{CH}-O)_c-(CH_2)_n\overset{R''}{CH}-NH_2,$$

S is a secondary amine-containing group of the formula:

$$-(CH_2CH_2-O)_a(CH_2\overset{CH_3}{CH}-O)_b(CH_2\overset{R'}{CH}-O)_c-(CH_2)_n\overset{R''}{CH}-\overset{R'''}{NH},$$

T is a tertiary amine-containing group of the formula:

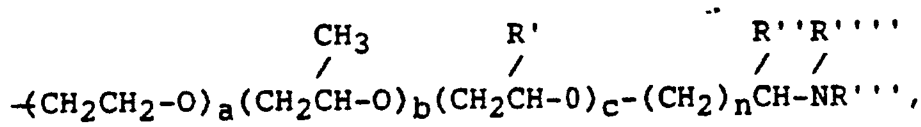

wherein a has a value of from zero to 175, b has a value of zero to 175, c has a value of zero to 30, n is an integer of from 1 to 3, R' is an alkyl group of 2 to 18 carbons, R" is hydrogen or an alkyl group of one to 18 carbon atoms, R"' and R"" are independently an alkyl group of 2 to 12 carbon atoms, p is a mole fraction and ranges from zero to 1.0, s is a mole fraction and ranges from zero to 1.0, t is a mole fraction and ranges from zero to 1.0, the quantity (p + s + t) equals one, w is the percent amination and ranges from 0.3 to 1.0 z is an integer from 2 to six and (zw) is the product of z and w.

**24.** The photoinitiator composition of Claim 23 wherein a is from zero to 90, b is from zero to 115, c is from zero to 15, R' is an ethyl group, R" is hydrogen or a methyl or ethyl group, and R"' and R"" contain from two to six carbon atoms.

**25.** The photoinitiator composition of Claim 23 wherein a is from zero to 50, b is from 3 to 98, c is from zero to 2, n is one.

**26.** The photoinitiator composition of Claim 23 wherein t is from zero to 0.2.

**27.** The photoinitiator composition of Claim 23 wherein a and c equal zero, b is 30 to 40, z equals 3, n equals one, and R" is methyl.

**28.** The photoinitiator composition of Claim 27 wherein p equals 0.65 to 1.0, s equals zero to 0.30, t equals zero to 0.05.

**29.** The photoinitiator composition of Claim 27 wherein p plus t equals zero to 0.30, s equals 0.70 to 1.0.

**30.** The photoinitiator composition of Claims 5 wherein R"' is isopropyl.

**31.** The photoinitiator composition of Claim 23 wherein R is $\{O\text{-}(CH_2)_4]_d\text{-}O\text{-}(CH_2)_4\text{-}O$-wherein d is from 0 to 50, a, b, and c equal zero, z equals 2, n equals 3, and R" is hydrogen.

**32.** The photoinitiator composition of Claim 29 wherein d is from 4 to 35.

**33.** The photoinitiator composition of Claim 23 wherein the aromatic ketone photosensitizer is benzophenone.

**34.** The photoinitiator composition of Claim 23 wherein the aromatic ketone photosensitizer is a mixture of benzophenone and isopropylthioxanthone.

**35.** The photoinitiator composition of Claim 23 which also contains one or more photoinitiators of the homolytic fragmentation type.

**36.** The photoinitiator composition of Claim 32 wherein the photoinitiator is 1-hydroxycyclohexylphenyl ketone.

**37.** The photoinitiator composition of Claim 32 wherein the photoinitiator is 2,2-diethoxyacetophenone.

**38.** The photoinitiator composition of Claim 30 wherein the photocurable composition also contains 1-hydroxycyclohexylphenyl ketone as a photoinitiator.

**39.** A process for preparing a photocured product comprising:
(1) mixing until homogeneous a photocurable composition of Claim 1, and
(2) exposing the photocurable composition to ultraviolet light for a sufficient length of time to cure the composition.

**40.** The cured product of Claim 39.